(19) Europäisches Patentamt
European Patent Office
Office européen des brevets

(11) **EP 3 427 310 B1**

(12) **EUROPEAN PATENT SPECIFICATION**

(45) Date of publication and mention of the grant of the patent:
**15.09.2021 Bulletin 2021/37**

(51) Int Cl.:
*H01L 39/02* (2006.01)    *H01L 39/08* (2006.01)
*H01L 39/06* (2006.01)    *H01L 39/12* (2006.01)
*H01L 39/24* (2006.01)

(21) Application number: **16893754.8**

(22) Date of filing: **10.03.2016**

(86) International application number:
**PCT/US2016/021664**

(87) International publication number:
**WO 2017/155531 (14.09.2017 Gazette 2017/37)**

(54) **SUPERCONDUCTING MICROWAVE-FREQUENCY VIAS FOR MULT-PLANAR QUANTUM CIRCUITS**

SUPRALEITENDE MIKROWELLENFREQUENZ-KONTAKTLÖCHER FÜR MULTIPLANARE QUANTENSCHALTUNGEN

TROUS D'INTERCONNEXION HYPERFRÉQUENCE SUPRACONDUCTEURS POUR CIRCUITS QUANTIQUES MULTIPLANAIRES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**16.01.2019 Bulletin 2019/03**

(73) Proprietor: **Technische Universiteit Delft**
**2628 CN Delft (NL)**

(72) Inventors:
• **BRUNO, Alessandro**
**2613 EP Delft (Zuid-Holland) (NL)**
• **POLETTO, Stefano**
**2631 LH Nootdorp (Zuid-Holland) (NL)**
• **DICARLO, Leonardo**
**2628 CJ Delft (Zuid-Holland) (NL)**

(74) Representative: **De Vries & Metman**
**Overschiestraat 180**
**1062 XK Amsterdam (NL)**

(56) References cited:
WO-A1-2008/086627    WO-A1-2010/123183
WO-A1-2015/143439    WO-A2-2014/168665
WO-A2-2015/178990    US-A1- 2006 255 876
US-A1- 2009 099 025    US-B1- 6 775 304
US-B1- 9 971 970    US-B2- 8 063 657

EP 3 427 310 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

Technical Field

This disclosure relates generally to the field of quantum computing, and more specifically, to vias for use in quantum circuits.

Background

Quantum computing, or quantum information processing, refers to the field of research related to computation systems that use quantum-mechanical phenomena to manipulate data. One example of quantum-mechanical phenomena is the principle of quantum superposition, which asserts that any two or more quantum states can be added together, i.e. superposed, to produce another valid quantum state, and that any quantum state can be represented as a sum of two or more other distinct states. Quantum entanglement is another example of quantum-mechanical phenomena. Entanglement refers to groups of particles being generated or interacting in such a way that the state of one particle becomes intertwined with that of the others. Furthermore, the quantum state of each particle cannot be described independently. Instead, the quantum state is given for the group of entangled particles as a whole. Yet another example of quantum-mechanical phenomena is sometimes described as a "collapse" because it asserts that when we observe (measure) particles, we unavoidably change their properties in that, once observed, the particles cease to be in a state of superposition or entanglement (i.e. by trying to ascertain anything about the particles, we collapse their state).

Put simply, superposition postulates that a given particle can be simultaneously in two states, entanglement postulates that two particles can be related in that they are able to instantly coordinate their states irrespective of the distance between them in space and time, and collapse postulates that when one observes a particle, one unavoidably changes the state of the particle and its' entanglement with other particles. These unique phenomena make manipulation of data in quantum computers significantly different from that of classical computers (i.e. computers that use phenomena of classical physics). Classical computers encode data into binary values, commonly referred to as bits. At any given time, a bit is always in only one of two states - it is either 0 or 1. Quantum computers use so-called quantum bits, referred to as qubits. Similar to a bit of a classical computer, at any given time, a qubit can be either 0 or 1. However, in contrast to a bit of a classical computer, a qubit can also be 0 and 1 at the same time, which is a result of superposition of quantum states. Entanglement also contributes to the unique nature of qubits in that input data to a quantum processor can be spread out among entangled qubits, allowing manipulation of that data to be spread out as well: providing input data to one qubit results in that data being shared to other qubits with which the first qubit is entangled.

Compared to well-established and thoroughly researched classical computers, quantum computing is still in its infancy, with the highest number of qubits in a solid-state quantum processor currently being about 10. One of the main challenges resides in protecting qubits from decoherence so that they can stay in their information-holding states long enough to perform the necessary calculations and read out the results. For that reason, qubits are typically operated at cryogenic temperatures, typically just a few millidegrees above absolute zero. The fidelity of gate operations and measurements on qubits is also the reason why current efforts of the industry focus on building qubits from superconducting materials. While qubits fabricated from superconducting metals arranged to model an atom are less precise than e.g. qubits built using single trapped ions, they are easier to assemble and couple in numbers.

Superconducting qubits are manipulated by microwave signals with frequency up to 20 gigahertz (GHz) used to control and read the qubits, and by direct current (DC) and nanosecond-rise-time flux pulses used to control qubits' working point, e.g. the qubits' operating frequency.

Currently, microwave signals and flux control pulses are typically delivered to target qubits using on-chip coplanar waveguides connected to external circuitry lines via traditional wirebonding at the edge of a chip. While the wirebonding solution for providing interconnects in a quantum processor may be satisfactory for the current limited number of qubits, it will face significant challenges if scaled to accommodate quantum processors with much larger number of qubits. Some challenges will arise from the fact that, as more qubits will be implemented on a chip, the surface area of the chip will increase by a much larger factor than the perimeter of the chip, leading to situations where there is not enough space at the edges of the chip to accommodate wirebonding to all of the qubits. In addition, the coplanar nature of the wirebonding approach excludes possibilities of multi-planar quantum circuits where circuit elements in different planes of a quantum stack will need to be electrically connected.

Fragility of the quantum states used in a quantum processor presents yet another challenge not found in classic computers - interconnects in quantum computers have to be able to transmit signals whose intensity is very small, such as signals where, on average, there is a single photon, or less, present in a signal line. For this reason, it is important that the electrical connections come as close as possible to being lossless.

As the foregoing illustrates, there remains room for improvement in the design of quantum circuits and, in particular, for improvement with respect to providing electrical connections in quantum circuits.

WO 2014/168665 A2 discloses a superconducting device having at least one enclosure and a method of manufacturing the device. The device includes multiple substrates arranged such that one or more troughs form at least one enclosure and a superconducting layer covers at least a portion of the at least one enclosure

US 2006/255876A1 discloses a compact via transmission line for a printed circuit board, the transmission line having a central conductor forming an inner conductor layer to make a single via hole and a plurality of via holes arranged around the central conductor form an outer conductor boundary layer.

The scope of protection of the present invention is defined by the appended independent claims. Optional features are specified by the dependent claims.

Brief Description of the Drawings

To provide a more complete understanding of the present disclosure and features and advantages thereof, reference is made to the following description, taken in conjunction with the accompanying figures, wherein like reference numerals represent like parts, in which:

FIG. 1 illustrates a perspective view of a cross section of an embodiment of a quantum IC package including a metallization stack for providing DC to microwave-frequency lossless connectivity in a quantum computing device, according to some embodiments of the present disclosure.

FIG. 2 provides an illustration of a cross-section of a metallization stack shown in FIG. 1, according to some embodiments of the present disclosure.

FIG. 3 provides an illustration of a top view of a coaxial arrangement of superconducting vias, according to some embodiments of the present disclosure.

FIG. 4 provides an illustration of a top view of a coaxial arrangement of superconducting vias surrounded by sparse ground vias, according to some embodiments of the present disclosure.

FIG. 5 provides an illustration of a perspective top-view of a metallization stack comprising superconducting signal and ground vias, according to some embodiments of the present disclosure.

FIG. 6 provides a flow chart of a method for forming a metallization stack comprising superconducting signal and ground vias, according to some embodiments of the present disclosure.

FIGs. 7A-7B provide an illustration of a cross-section of a metallization stack shown in FIG. 1 connected to, respectively, a coaxial cable and a printed circuit board (PCB), according to some embodiments of the present disclosure.

FIG. 8 provides another schematic illustration of a metallization stack comprising a coaxial arrangement of signal and ground vias, according to some embodiments of the present disclosure.

FIGs. 9A-9C provide schematic illustrations of connecting the metallization stack of FIG. 8 to a coaxial cable, in various configurations, according to different embodiments of the present disclosure.

FIGs. 10A and 10B provide schematic illustrations of vertical stacks of multiple metallization stacks such as the one shown in FIG. 8, in various configurations, according to different embodiments of the present disclosure.

FIG. 11 provides an illustration of a cross-section of a vertical stack of three metallization stacks as shown in FIG. 2 connected to two coaxial cables, according to some embodiments of the present disclosure.

FIG. 12 is a quantum computing device, according to some embodiments of the present disclosure.

Detailed Description

As the foregoing description illustrates, building a quantum processor presents unique challenges not encountered in classical computing. The challenges are unique due to, both, the physics of data manipulation being different from that of classical computers (e.g. superposition, entanglement, and collapse), and the physical systems suitable to build a quantum processor being different (e.g. superconducting materials are used for providing DC to microwave-frequency lossless connectivity and cryogenic temperatures). Described herein are systems and methods for providing a metallization stack to be used in a quantum integrated circuit (IC) package of a quantum computer.

As used herein, a term "metallization stack" refers to a structure for providing electrical conductivity between, i.e. interconnecting, two or more quantum circuit components provided in different planes, or levels, of a quantum IC package. Such components include various components associated with one or more quantum circuits of a quantum IC package and may include, for example, qubits, microwave signal lines, resonators, amplifiers, filters, circulators, etc.

When describing a metallization stack, present disclosure differentiates between superconducting lines and superconducting vias of a metallization stack. A term "superconducting line" (or simply "line") is used to describe an electrically superconducting element realized on an interconnect support layer within a single plane, e.g. a coplanar waveguide (CPW). Besides providing support for realizing electrical interconnections, an interconnect support layer may also provide support for realizing components of one or more quantum circuits. For example, an interconnect support layer may be a substrate having one or more quantum circuit components (therefore, in the following, the terms "interconnect support layer" and "substrate" are used interchangeably). Embodiments of the present disclosure provide for the possibilities that such quantum circuit components may be stacked into several levels (e.g. be provided on the top and the bottom surface of a single substrate, or/and be provided on different substrates stacked over one another), thus allowing to build multi-planar quantum circuits or multi-planar quantum IC packages. In this context, the term "superconducting via" (or simply "via") is used to describe an electrically superconducting element interconnecting quantum circuit components in different levels, i.e. quantum circuit components which are not coplanar. Such vias would typically be provided substantially perpendicularly to the plane of a quantum IC chip. A via may be used to interconnect two superconducting lines in different levels, in which case the superconducting lines may be viewed as quantum circuit components as well.

A via as described above, i.e. used to provide electrical interconnection between quantum circuit components in different planes and extending all the way through the interconnect support layer to connect the different planes, may be referred to as a "through via." On the other hand, a term "blind via" may be used to describe an opening in the interconnect support layer that is provided substantially parallel to how a through via may be provided but, unlike the through via, does not extend all the way to the opposite surface of the interconnect support layer and does not have a conformal superconducting metallization on its sidewalls. Such blind vias may be used to e.g. locally modify the dielectric constant of the interconnect support layer, which, in turn, modifies the impedance of the interconnect support layer and may be used e.g. for impedance matching. In the following, unless otherwise specified, reference to a "via" is intended to indicate a through via. Blind vias are referred to as "blind vias."

In various embodiments, quantum circuit components may include any components associated with a quantum IC and may include those that are mounted on or embedded in a quantum IC, or those connected to a quantum IC. The quantum IC may be either analog or digital and may be used in a number of applications, such as quantum processors, quantum amplifiers, quantum sensors, etc., depending on the components associated with the integrated circuit. The integrated circuit may be employed as part of a chipset for executing one or more related functions in a quantum computer.

In one aspect of the present disclosure, a metallization stack for providing direct current (DC) to microwave-frequency lossless connectivity in a quantum processor is disclosed. The metallization stack includes a substrate having a patterned top superconducting surface and a patterned bottom superconducting surface, the substrate configured to house at least one quantum circuit component and comprising one or more superconducting vias extending between the patterned top surface and the patterned bottom surface of the substrate (i.e. one or more through vias). The vias may be fabricated as deep-reactive-ion-etched (DRIE) openings through the substrate, the openings having inner sidewalls which are conformally coated with a superconducting material, thus providing DC to microwave-frequency lossless connectivity to the at least one quantum circuit component housed by the substrate.

As used herein, an expression of providing "DC to microwave-frequency connectivity" is used to describe the fact that metallization stacks described herein are used to transmit both DC signals as well as microwave-frequency signals. As used herein, an expression of providing "lossless connectivity" is used to describe transmission of electrical signals without, or with negligible, dissipation.

In some embodiments, a metallization stack may include a superconducting signal via extending between a patterned top superconducting surface and a patterned bottom superconducting surface of a substrate, and a plurality of superconducting ground vias extending between the patterned top and bottom surfaces of the substrate substantially parallel to the signal via. If viewed from the top surface or the bottom surface of the substrate (i.e. in the plane of the substrate or parallel to the plane of the substrate), the superconducting ground vias may be arranged in a ring, with the signal via being at a center of the ring, an arrangement referred to herein as "coaxial." The signal via and the plurality of ground vias are configured to provide DC to microwave-frequency connectivity to the at least one quantum circuit component housed by the substrate by virtue of each via being implemented as an opening having inner sidewalls coated with a layer of a superconducting material having a thickness of at least 50 nanometers (nm).

In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

Implementations of the disclosure may be formed or carried out on a substrate suitable for realizing quantum circuit components. In one implementation, the substrate may be a crystalline substrate such as, but not limited to a silicon or a sapphire substrate. In general, any material that provides sufficiently good electrical isolation may be used.

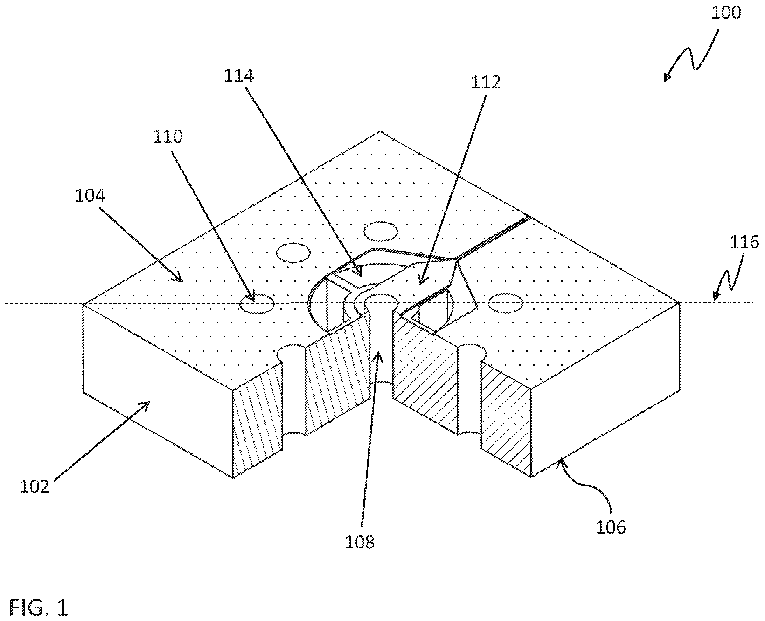

FIG. 1 illustrates a perspective view of a cross section of an embodiment of a quantum package 100 including a metallization stack for providing DC to microwave-frequency connectivity in a quantum device, according to some embodiments of the present disclosure. The perspective view depicted in FIG. 1 shows a cut-out of one quarter, in order to illustrate constituent elements of the quantum package 100.

A metallization stack may be considered to include an interconnect support layer 102 having a top surface 104 and a bottom surface 106 indicated in FIG. 1.

In some embodiments, the interconnect support layer 102 may be a dielectric substrate such as e.g. an intrinsic silicon or a sapphire substrate, used for implementing quantum circuit components on, e.g. superconducting qubits. In other embodiments, the interconnect support layer 102 may be such that it does not implement quantum circuit components as such but merely serves to provide electrical connections to quantum circuit components provided above or below the layer. For example, such an interconnect support layer may serve as an interposer, i.e. a layer between two substrates each implementing quantum circuit components, where the layer is configured to provide electrical interconnection between these substrates.

In various embodiments, the interconnect support layer 102 may have a thickness in the range of 100 micrometers (micron) to 1000 micron, including all values and ranges therein.

Each of the top and the bottom surfaces of the interconnect layer 102 are coated with a layer of one or more superconducting materials, patterned to provide suitable electrical connections, form qubits, and implement other quantum circuit components. The dotted parts of the top surface 104 of the interconnect support layer shown in FIG. 1 illustrate patterned superconducting layer. In other words, the dotted parts of the top surface 104 shown in FIG. 1 are superconducting, whereas parts not shown as dotted are insulating, which can be achieved by e.g. depositing the superconducting layer onto the substrate 102 and then etching the superconducting layer to obtain a patterned layer, using any one of the known techniques. In this manner, superconducting lines of a metallization stack may be formed, shown in FIG. 1 with a superconducting line 112 on the top surface 104. Although not shown in FIG. 1, similar patterning is done on the bottom surface 106. Patterned superconducting lines, such as the line 112, may be considered to be a part of a metallization stack.

A metallization stack further includes a plurality of vias, shown in FIG. 1 as a signal via 108 and a plurality of ground vias 110. The signal via 108 is a superconducting via and is electrically connected to the top superconducting signal line 112 provided over the top surface 104 as well as to a bottom superconducting signal line (not shown in FIG. 1) provided at the bottom surface 106. The ground vias 110 are superconducting vias electrically connected to the patterned superconducting ground portion, which, in FIG. 1, is the dotted part provided over the top surface 104 except for the line 112. The ground vias 110 are also electrically connected to the patterned superconducting ground portion (not shown in FIG. 1) provided at the bottom surface 106.

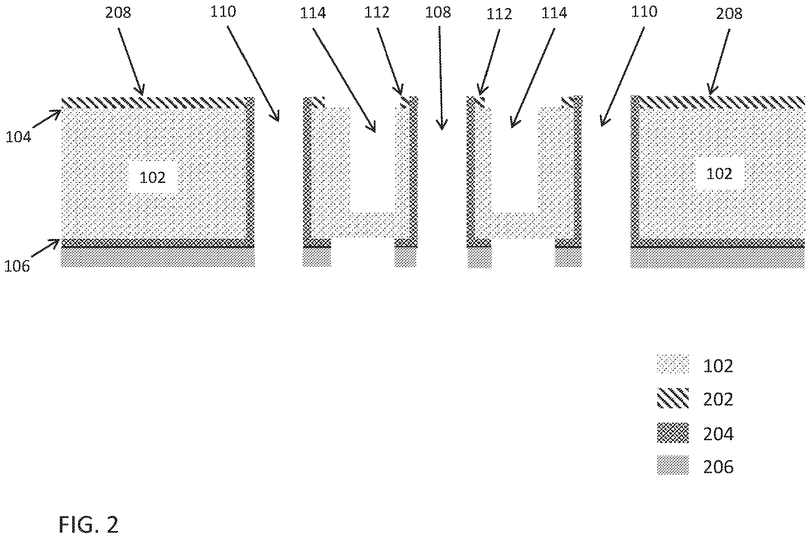

The vias 108, 110 are superconducting in that each of the signal and ground vias 108, 110 is implemented as an opening, typically a relatively high aspect ratio opening, the inner sidewall of which is conformally coated with a layer of superconducting material that is thick enough to support connectivity from DC to microwave frequencies. Such inner sidewall layers are not shown in FIG. 1 in order to not clutter the drawing, but are shown in FIG. 2 illustrating a cross-section of an exemplary metallization stack such as e.g. the one shown in FIG. 1, the cross-section being taken e.g. along a plane illustrated in FIG. 1 with a dashed line 116.

Thus, the top superconducting ground plane (dotted parts of the surface 104 except for the superconducting signal line 112) is connected to the bottom superconducting ground plane (not shown) via the ground vias 110, while the top superconducting signal line 112 is connected to the bottom superconducting signal line (not shown) via the signal via 108. In this manner, the metallization stack provides a vertical path connecting different levels of a quantum IC package for microwave signals controlling and reading the qubits (not shown) as well as for flux pulses for controlling the qubit working point.

In some embodiments, the metallization stack may further, optionally, include one or more blind vias 114, i.e. vias that are provided in the interconnect support layer 102 e.g. from the top surface 104 but do not extend all the way to the bottom surface 106. Such blind vias may be used to obtain appropriate impedance matching for the electrical signals transmitted over the metallization stack.

The remaining surface at the bottom of the blind vias 114 may be used to absorb infrared (IR) radiation, which may help increasing the energy relaxation time of qubits implemented on the substrate 102. To that end, various techniques may be employed to modify the bottom surface 104 to increase IR absorption, such as e.g. surface finishing techniques to fabricate so-called "black silicon," i.e. silicon having relatively high absorption of IR (and visible) radiation.

FIG. 2 provides an illustration of an interconnect support layer 102 showing the signal via 108, two ground vias 110, and two blind vias 114 as those shown in FIG. 1 along the dashed line 116.

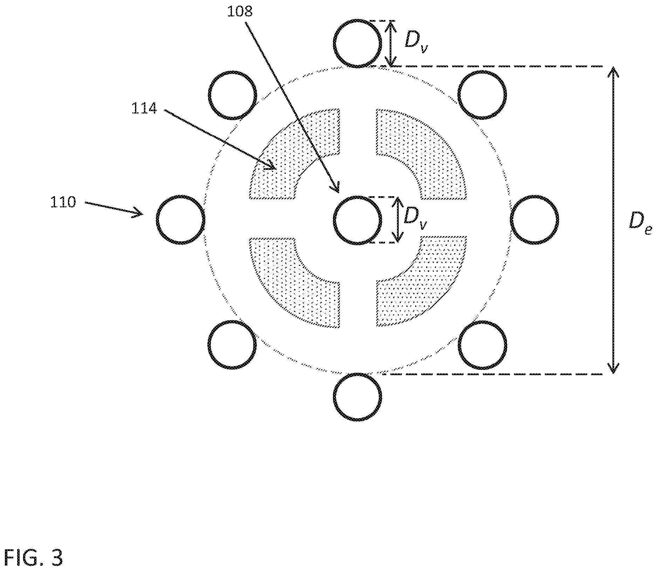

In various embodiments, a diameter of the openings for the signal and ground vias 108, 110 may be between 10 and 160 micron, including all values and ranges therein. As described in detail below with reference to FIG. 3, diameter of the openings for the signal and ground vias may be selected to achieve desired impedance for the most efficient transmission of DC to microwave-frequency signals.

The openings for the signal and ground vias 108, 110 are openings with relatively high aspect ratio, with the ratio between a depth of the opening and a diameter of the opening being between approximately 7 and 50, including all values and ranges therein. Such openings may be formed using e.g. deep-reactive-ion etching (DRIE).

FIG. 2 further illustrates the top and the bottom surfaces 104, 106 of the interconnect support layer 102, as well as the superconducting signal line 112 shown in FIG. 1. In addition, FIG. 2 illustrates a patterned superconducting layer 202 provided over the top surface of the interconnect support layer 102, and an inner sidewall layer 204 provided within the via openings of the through vias 108 and 110. Parts 208 of the patterned superconducting layer 202 indicate the top superconducting ground plane described above, while parts 112 of the patterned superconducting layer 202, also indicated in FIG. 2, illustrate the top superconducting signal lines.

In some embodiments, the patterned superconducting layer 202 may be a layer of niobium titanium nitride (NbTiN), while the superconducting layer 204 conformally coating the vias may be a layer of titanium nitride (TiN). However, in other embodiments, layers 202 and 204 may be of the same superconducting material, which could include any other superconducting materials besides NbTiN and TiN, such as e.g. niobium (Nb), niobium nitride (NbN), aluminum (Al), molybdenum rhenium (MoRe), etc.

Furthermore, FIG.2 illustrates an embodiment in which the bottom surface 106 of the interconnect support layer 102 is coated with a patterned layer of the same superconducting material as that used for coating of the sidewalls of the vias 108, 110, e.g. TiN. However, in other embodiments, the patterned superconducting layer coating the bottom of the interconnect support layer 102 could include any other superconducting material, e.g. one or more of the exemplary superconducting materials described above.

In various embodiments, the patterned superconducting layers provided at the top and the bottom of the interconnect support layer 102 to realize superconducting quantum circuits may have thickness between 10 and 300 nm, including all values and ranges therein.

As described above, in order to preserve states of the qubits for the duration of time necessary to carry out quantum computations, quantum circuits are typically maintained at cryogenic temperatures. This unique feature of quantum circuits needs to be accounted for when building metallization stacks for providing electrical connectivity. Therefore, FIG. 2 further illustrates that an additional patterned layer may, optionally, be provided over the patterned superconducting layer at the bottom 106 of the interconnect support structure, shown in FIG. 2 as a patterned layer 206, which could comprise e.g. Indium (In). Such a layer may be used to assist cryo-compatible soldering and a superconducting electrical connection when multiple layers 102 are stacked. In various embodiments, such a layer may have a thickness between 1 and 100 micron, including all values and ranges therein. In various embodiments, besides single-element Indium, some of its alloys may be used as well.

In addition, a layer that improves soldering reliability may, optionally, be provided between layers 204 and 206 shown in FIG. 2, this layer comprising e.g. an alloy of gold and palladium (AuPd alloy). Thus, in some embodiments, a layer of AuPd maybe interposed between the bottom ground plane 204, e.g. TiN, and the soldering layer 206, e.g. In. Such a layer may have a thickness between 5 and 100 nm, including all values and ranges therein, and could be e.g. about 30 nm. In various embodiments, besides AuPd alloy, also gold (Au), titanium (Ti) and chromium (Cr) may be used as well.

Preferably, the superconducting ground vias 110 are arranged in a ring with the signal via 108 being at the center of the ring, approximating a coaxial cable configuration used in classical devices. Such a coaxial arrangement may be inferred from FIGs. 1 and 2, but FIG. 3 illustrates it specifically by showing a top view of a metallization stack such as the one shown in FIGs.1 and 2.

FIG. 3 illustrates an example showing the signal via 108 and the ground vias 110 as described above, as well as some exemplary blind vias 114. In various embodiments, any number of ground vias 110 arranged in a ring may be implemented, depending on particular design considerations. For example, the number of the ground vias arranged in a ring may be selected based on maximum allowed signal leakage (if a small number of ground vias is employed) or mechanical stability (too many ground vias).

Furthermore, in other embodiments, blind vias 114, if at all present, may have different shapes and locations than those shown in FIG. 3.

Distances $D_v$ and $D_e$ shown in FIG. 3 illustrate, respectively, a diameter of the signal via 108 and a distance between the closest points of each pair of the opposite ground vias 110. Distance $D_e + 2 D_v$ may be considered as a value representative of the overall footprint of the metallization stack of the signal via 108 surrounded by a ring of ground vias 110. The values of $D_v$, $D_e$, and impedance $Z_0$ of the metallization stack are interrelated according to the following equation:

$$Z_0 = 138 \log_{10}\left(\frac{D_e}{D_v} \times \frac{1}{\sqrt{\varepsilon_r}}\right)$$

where $\varepsilon_r$ is the dielectric constant of the interconnect support layer 102.

Typically, dielectric constant $\varepsilon_r$ is set based on the material used for the interconnect support layer 102, signal via diameter $D_v$ is set based on the fabrication considerations of the via openings. The value of $D_e$ is then selected to achieve the desired impedance, e.g. to achieve impedance of 50 Ohm ($\Omega$).

In some embodiments, blind vias may also be implemented as circular openings, similar to the signal and ground vias. In such embodiments, the diameter of blind vias may be selected based on the diameter $D_v$ of the signal vias, e.g. as 2/3 of the diameter $D_v$, in order to exploit the aspect-ratio-dependent etching characteristic of DRIE and realize vias which are not open to the bottom side of the interconnect support layer. In various embodiments, fractions other than 2/3 may be used, the actual fraction being selected depending on the specific DRIE process used. FIG. 3 provides an illustration of a top view of a coaxial arrangement of superconducting vias, according to some embodiments of the present disclosure.

As an example, the following approximate values and ranges may be used for a design of a metallization stack comprising a coaxial arrangement of signal and ground vias as described herein to realize an impedance matched connection to a UT-47 coaxial cable:

- Overall interconnect footprint: 1.2 mm$^2$

- Via diameter $D_v$: 160 micron

- External via ring diameter $D_e$: 1 mm

- Substrate thickness: 300-525 micron

- TiN layer thickness (e.g. layer 204 in FIG. 2): 100 nm

- AuPd layer thickness: 30 nm

- Indium layer thickness (e.g. layer 206 in FIG. 2): 1-100 micron

- Dielectric spacer thickness (described below): 0.1-100 micron

As another example, the following approximate values and ranges may be used for a design of a metallization stack comprising a coaxial arrangement of signal and ground vias as described herein to realize an impedance matched connection to a PCB circuit:

- Overall interconnect footprint: 0.2 mm$^2$

- Via diameter $D_v$: 40 micron

- External via ring diameter $D_e$: 400 micron

- Other dimensions may be similar to the previous example

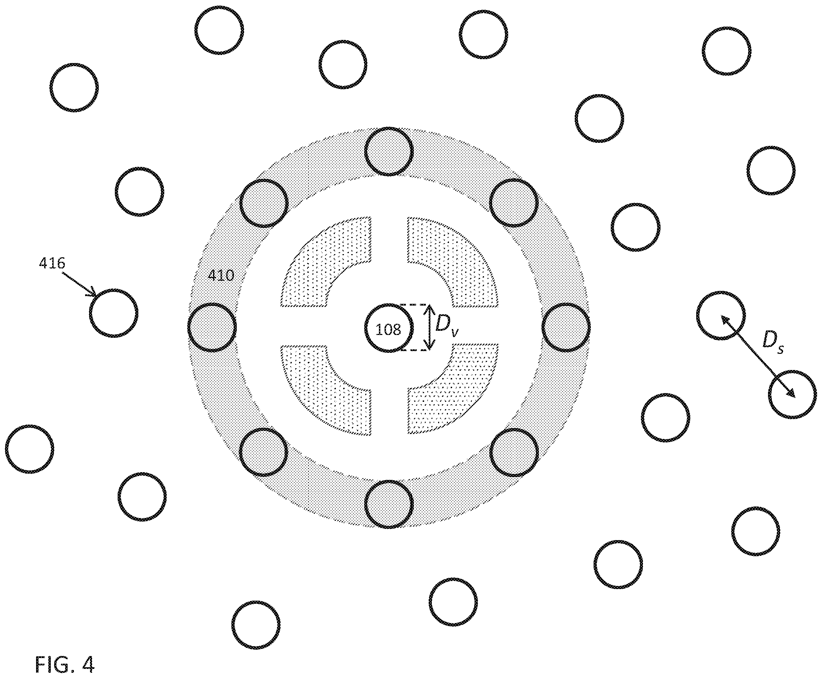

In some embodiments, besides superconducting ground vias implemented in a ring arrangement around the central signal via, a metallization stack may also, optionally, include additional ground vias. Such additional ground vias could be implemented in the same manner as the ground vias 110, connecting the different ground planes of the patterned superconducting layers, but provided in a sparse arrangement around the ring ground vias and other quantum circuit components that may be realized on the top and bottom patterned superconducting surfaces 104 and 106. This is illustrated in FIG. 4, providing a top view of a coaxial arrangement of superconducting vias, where the ground vias 110 arranged in a ring around the central signal via 108 as shown within a ring 410, and the sparse ground vias are shown outside of the ring 410 as vias 416. Such vias may advantageously be used to reduce microwave slotline-modes propagation in the quantum IC package, reduce cross-coupling (crosstalk) between on-chip microwave elements, and to push resonant substrate modes to higher frequencies. FIG. 4 provides an illustration of a top view of a coaxial arrangement of superconducting vias and a sparse arrangement of ground vias, according to some embodiments of the present disclosure.

In order for the sparse ground vias 416 to be effective in suppressing microwave slot modes, cross-coupling between circuital blocks, and substrate resonant modes, such vias may be provided at a distance from one another that is less than about $\lambda/10$, where $\lambda$ is the effective wavelength of the microwave signal in the dielectric substrate 102. In this context, the "distance" between sparse ground vias is defined as a distance between the closest points of two neighboring vias (i.e. along the line connecting the centers of the two vias), shown in FIG. 4 with a distance Ds. Preferably, the sparse ground vias 416 are provided as close to one another as equal to or less than $\lambda/20$.

Another design consideration for selecting configuration of the sparse ground vias 416 is that, preferably, such vias are provided at a distance of about or greater than λ/300 from any circuit element present on the top and bottom superconducting surfaces. This is important in order to avoid unintentional coupling between circuit elements on the same or on different planes.

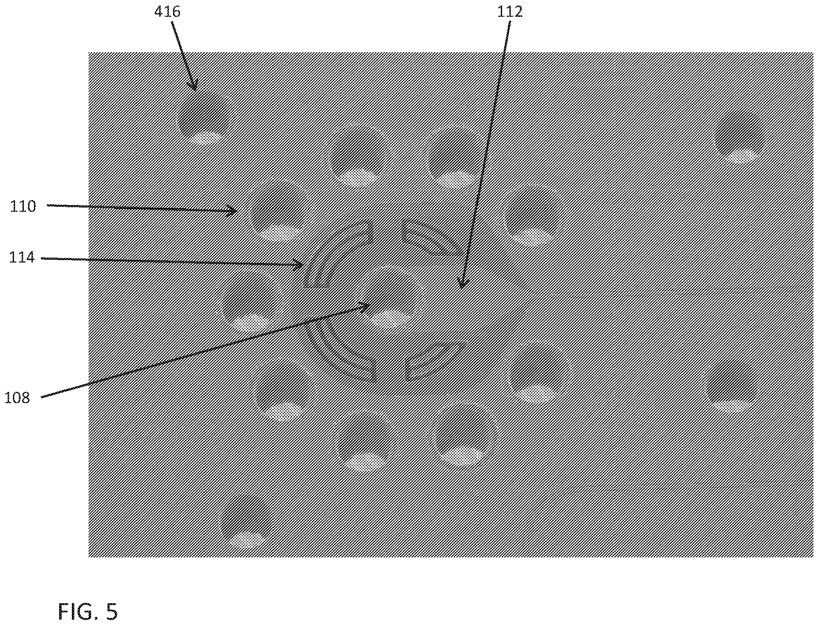

It should be noted that, for simplicity, various parts of the metallization stack of the quantum IC packages described herein are shown in the figures to be rectangular in their cross-sections and via openings are shown to be perfectly circular in their top views. However, in various embodiments, other geometries may be assumed for the cross sections as well as for top views of different parts of the metallization stacks described herein such as e.g. square, oblong, elliptical or variations thereof. In fact, in practice, fabricated interconnects rarely have perfectly rectangular cross sections, as e.g. is illustrated in FIG. 5 with an illustration of a scanning electron microscopy (SEM) image of a perspective view of an exemplary interconnect. FIG. 5 illustrates an example of a real fabrication process and limitations of such a process, in that the features described herein (e.g. the signal via 108, the ground vias 110 and 416, the blind vias 114, and the signal line 112 shown in FIG. 5) are not shown with precise right angles, straight lines, and perfect curves.

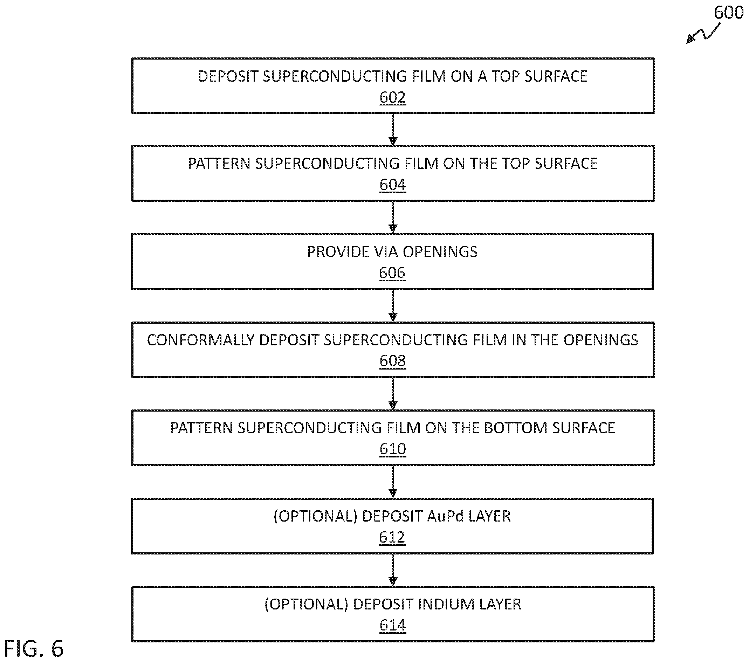

Advantageously, metallization stacks for quantum circuits as described herein may be fabricated using standard IC manufacturing techniques as known in the art. In some embodiments, a method as shown in FIG. 6 may be used.

As shown, the method 600 may begin with providing a superconducting film on the top surface 104 of an interconnect support layer (box 602). Deposition of such film may be performed using magnetron sputtering or evaporation techniques or by a conformal coating process such atomic layer deposition (ALD) or chemical vapor deposition (CVD). A conformal coating is understood as a coating that is applied to exposed surfaces of an interconnect support layer, including the sidewalls and bottom of any openings that may be present in the interconnect support layer (i.e. coating it not limited to, for example, only the horizontal surfaces).

The superconducting film provided on the top surface 104 may then be patterned (box 604). To that end, any kind of patterning techniques for patterning superconducting, or any metal, materials may be used, including etching or lift-off processes. In an embodiment, patterning includes depositing a photoresist over the superconducting top surface. The photoresist may be a positive or negative resist and may include for example, poly(methyl methacrylate), poly(methyl glutarimide), DNQ/novolac, or ZEP. The photoresist may be deposited by a casting process such as, for example, spin-coating or spray coating. The photoresist may then be patterned by optically projecting an image of a desired pattern onto the photoresist using photolithography, such as optical photolithography, immersion photolithography, deep UV lithography, extreme UV lithography, electron beam lithography, or any other suitable technique. A developer, such as tetramethylammonium hydroxide (TMAH) or potassium hydroxide (KOH) may be applied to the photoresist, such as by liquid immersion or spray, and portions of the photoresist are removed to expose regions of the underlying superconducting top surface correlating to the desired pattern.

In some embodiments, baking of the interconnect support layer may occur before or after any of the above actions. For example, the interconnect support layer may be prebaked to remove surface water from the interconnect support layer or/and the superconducting top surface. In some embodiments, prebaking may be performed at a temperature in the range of 200° C to 400° C, including all values and ranges therein, for a time of 5 to 60 minutes, including all values and ranges therein. After application of the photoresist, a post application bake may occur, wherein at least a portion of the solvents in the photoresist are driven off. A post application bake is, for example, performed at temperatures in the range of 70° C to 180° C, including all values and ranges therein, for a time period in the range of 60 seconds to 240 seconds, including all values and ranges therein. After patterning, the resist may be hard baked at a temperature in the range of 100° C to 300° C, including all values and ranges therein, for a time period of 1 minute to 10 minutes, including all values and ranges therein.

The exposed portions of the superconducting top surface may then be physically and/or chemically etched, wherein the exposed portions of the superconducting surface are removed until the underlying dielectric surface 104 of the interconnect support layer is exposed. The remaining photoresist may optionally be removed via a process such as ashing, wherein the photoresist is exposed to oxygen or via solvent stripping.

Next, via openings may be formed (box 606). To that end, a suitable hard mask is placed on the top surface of the interconnect support and deep-reactive-ion-etch (DRIE) may be used to etch the openings for both the through and the blind vias, until a desired depth is achieved, typically using fluorine based Bosch process or cryogenic deep etching in an Inductively Coupled Plasma (ICP) reactor. A silicon oxide (SiO) hard mask may be employed both for the DRIE of the interconnect support structure and to protect the top superconducting surface during some of the subsequent fabrication steps, such as the TiN conformal deposition. Besides a SiO hard mask, thick resist and dry resist films may be used as DRIE mask. Advantageously, blind vias may be realized in the same DRIE step as the through vias, exploiting the aspect-ratio-dependent etch (ARDE). The interconnect support layer at least partially surrounds the openings, isolating them from each other both physically and electrically.

Next, superconducting film may be provided on the bottom surface 106 of the interconnect support layer 106 and on the inner sidewalls of the openings for the through vias (box 608). The superconducting film may advantageously be provided on the bottom surface 106 of the interconnect support layer 106 and on the inner sidewalls of the openings for the through vias at the same time by using any of the conformal deposition processes described above. That is why the illustration of FIG. 2 shows the same superconducting material 204 being deposited at the bottom surface and on the inner sidewalls of the via openings. By having the bottom surface of the interconnect support layer facing the material source, the inner sidewalls of the through vias would be conformally coated with the superconducting material while blind vias would not be coated (because they would be facing away from the deposition source). This is also shown in FIG. 2 illustrating that there is no superconducting layer 204 within the blind vias 114.

Of course, in other embodiments, fabrication steps shown in FIG. 6 may be modified so that different superconducting materials are provided at the bottom of the interconnect support layer and on the inner sidewalls of the through via openings. In some embodiments, the superconducting material is provided on the bottom of the interconnect support layer separately from conformal deposition of box 608, and may take place either before or after said conformal deposition.

The superconducting material deposition of box 608 may (e.g. TiN deposition) realize in a single step the bottom ground plane, the conformal via sidewall coating and the electrical connection with the top superconducting layer (e.g. NbTiN). Preferably, the superconducting layer on the inner sidewalls of the through vias is deposited to achieve an average thickness of more than 100 nm, in order to ensure good conformal coverage in the high aspect ratio features and to decrease the kinetic inductance of the film.

Next, the bottom superconducting film is patterned (box 610), which may be done in a manner similar to that described above the top superconducting film.

Next, optionally, an AuPd layer may be interposed (box 612) between the patterned bottom ground plane (i.e. TiN) in order to improve the soldering reliability, and, also optional, an Indium layer may be deposited (box 614). Both of these layers may be deposited on specific positions of the chip to realize a cryo-compatible soldering and a superconducting electrical connection to external input/output (I/O) structures such as, but not limited to coaxial cables, PCBs, etc., or when multiple wafers are stacked.

In this manner, high-aspect-ratio, superconducting vias and coaxial interconnect for multi-planar microwave circuits may be fabricated. The exemplary process described above advantageously eliminates the need for metal filling, using instead selective conformal deposition of a superconductor. Such a process provides robust superconducting contact between superconducting films on both sides of a substrate, and across stacked substrates.

Metallization stacks as described herein solves the problems of the wirebonding approach by providing connectivity to any desired location of a quantum processor and by controlling the substrate modes. Geometry of the through vias coated with a conformal superconductor and of the blind vias may be optimized as described above to control impedance at microwave frequencies, suppress the crosstalk between on-chip microwave elements, avoid spurious propagating modes, provide shielding from the IR radiation, and ensure reliable mechanical and electrical connections at cryogenic temperatures.

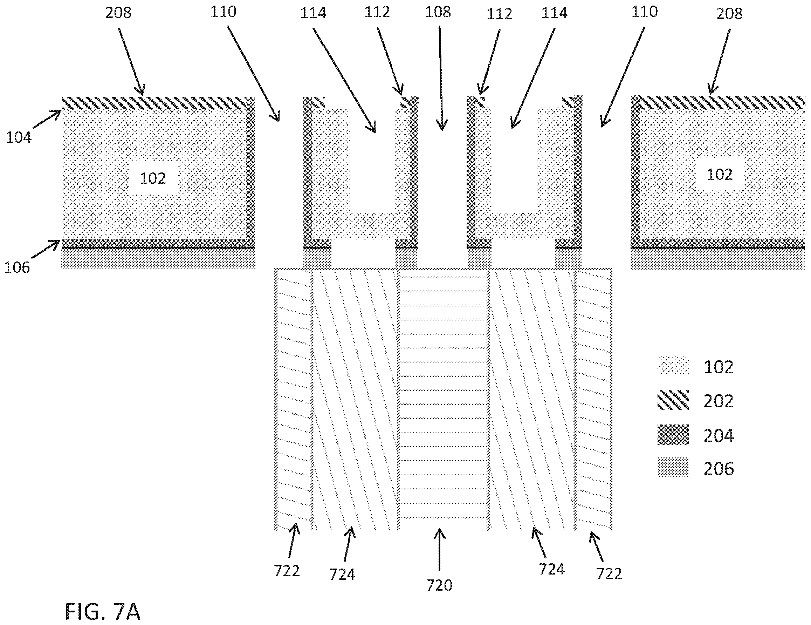

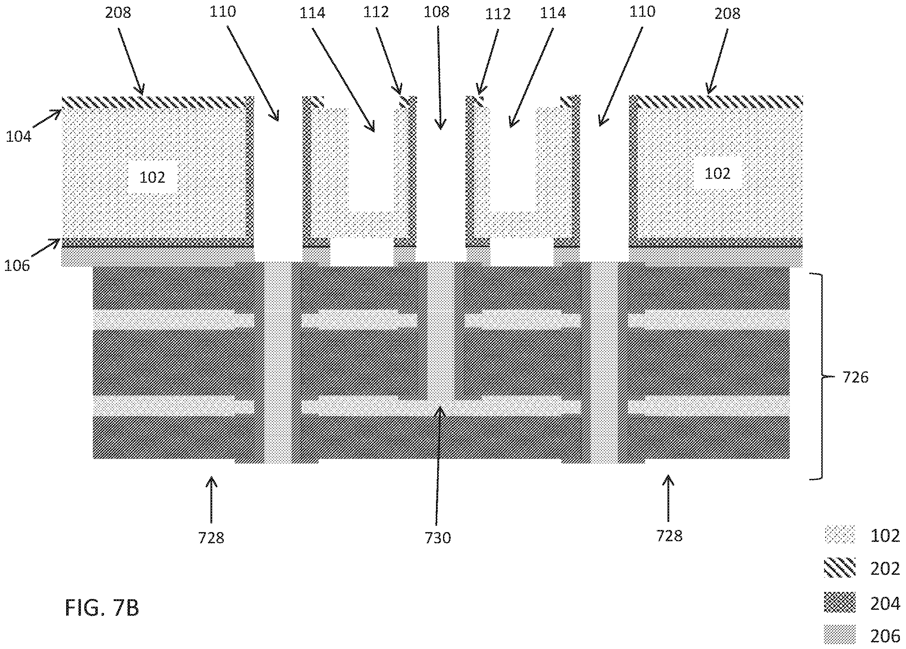

Metallization stacks described herein are very versatile in that design parameters may be adjusted to achieve specific goals, such as e.g. vertical interconnect at microwave frequency or substrate mode suppression. Furthermore, by patterning the superconducting film of the top or/and the bottom surfaces, coaxial vias may be connected to any external circuitry, connecting the quantum IC chip e.g. to coaxial cables, PCBs, or other supports. For example, Indium, being a thick and ductile superconducting material, may be used to connect the patterned superconducting ground plane of the bottom surface to an external circuitry, ensuring reliable electrical and mechanical connectivity over a wide range of operational temperatures. FIG. 7A provides an illustration similar to that of FIG. 2, but further illustrating that the metallization stack is connected to a coaxial cable having a coaxial cable center pin 720, a coaxial cable outer metal 722, and coaxial cable dielectric 724. FIG. 7B provides an illustration similar to that of FIG. 2, but further illustrating that the metallization stack is connected to a multilayer PCB 726 having a PCB ground 728 and a PCB signal line 730.

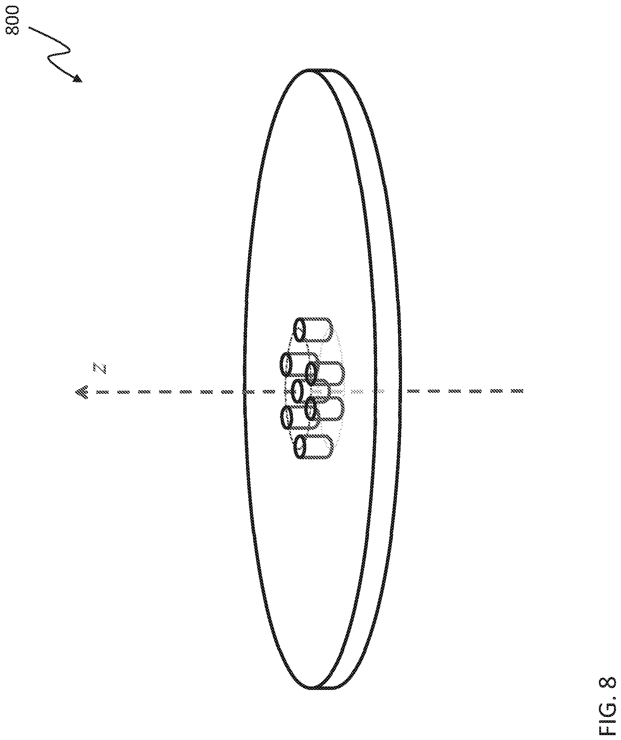

FIG. 8 provides another schematic illustration of a metallization stack 800 comprising a coaxial arrangement of superconducting signal and ground vias, according to some embodiments of the present disclosure. In FIG. 8, the superconducting signal via is provided along the z axis. The metallization stack 800 may be implemented as any of the metallization stacks described above and illustrated in the previous figures, even though not all elements of the previous figures are shown in FIG. 8 (e.g. superconducting signal lines and patterned ground planes are not shown), and may include blind and sparse ground vias as well, although also not shown in FIG. 8.

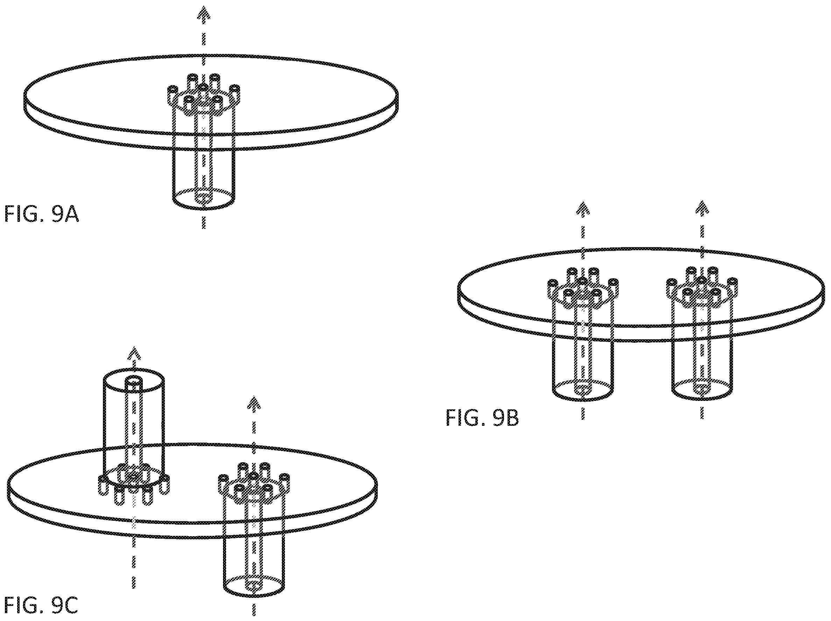

FIGs. 9A-9C provide schematic illustrations of connecting the metallization stack of FIG. 8 to a coaxial cable, in various configurations. Connection may be achieved as described above with reference to a coaxial cable connection shown in FIG. 7. FIGs. 9A-9C illustrate that metallization stacks as described herein allow providing paths to any point on a substrate, from DC to microwave frequencies.

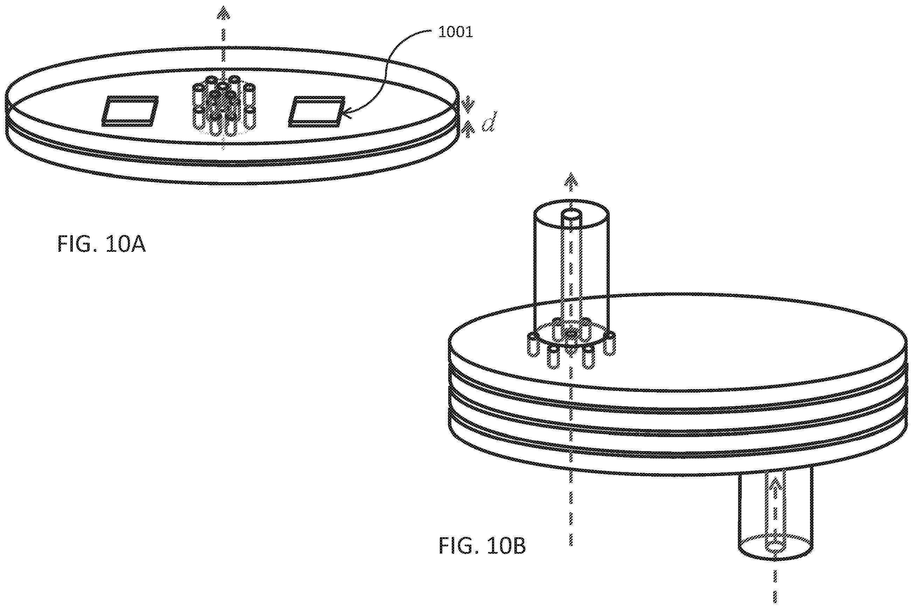

FIGs. 10A and 10B provide schematic illustrations of vertical stacks of multiple metallization stacks such as the one shown in FIG. 8, in various configurations. Such stacks may be used to provide multiple vertical input and output from the bottom of the lowest substrate and the top of the topmost substrate. FIG. 10A illustrates an example of two metallization stacks stacked over one another, while FIG. 10B illustrates an example of four metallization stacks stacked over one another, further showing connections to two coaxial cables. The latter connections may be achieved as described above with reference to a coaxial cable connection shown in FIG. 7.

As indicated in FIG. 10A, but applicable to all embodiments where multiple metallization stacks are stacked vertically, one or more dielectric spacers of thickness d may be provided between the different metallization stacks to control the inter-wafer distance in case it is necessary to maintain the latter above a minimum value in order to allow the correct working of circuits present on the top superconducting surface. Element 1001 shown in FIG. 10A illustrates an exemplary dielectric spacer (two of those are shown in FIG. 10A).

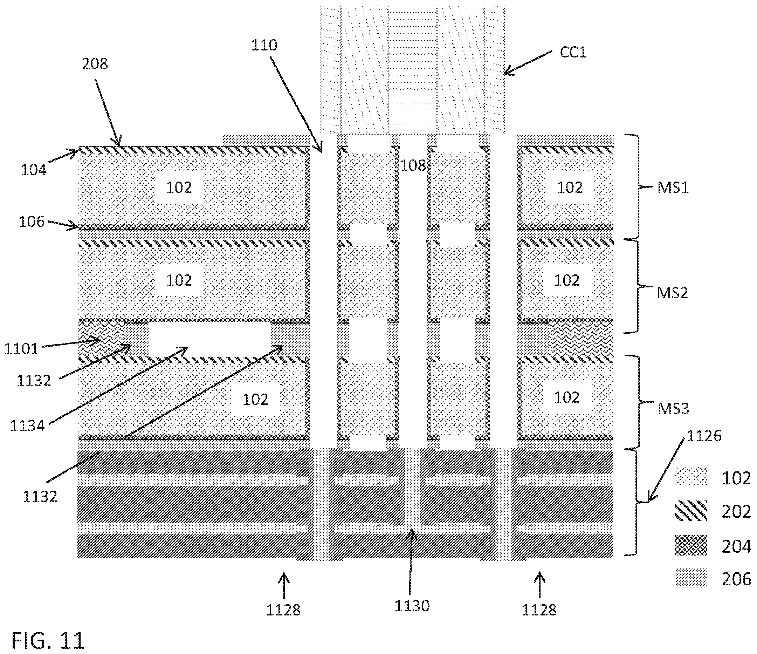

In addition, a combination of dielectric spacers and superconducting spacers may be provided (not shown in FIGs. 10A-10B but shown in FIG. 11) to create inter-wafer cavities whose self-resonant modes are pushed up in frequency by limiting the lateral dimension of the inter-wafer cavities.

FIG. 11 provides an illustration of a cross section of a vertical stack of three metallization stacks (MS1, MS2, and MS3) as shown in FIGs. 2 and 7 connected to two coaxial cables (CC1, CC2), according to some embodiments of the present disclosure. FIG. 11 illustrates elements analogous to those shown in FIGs. 7A and 7B, except that FIGs. 7A and 7B illustrate a single metallization stack connected to one coaxial cable or a PCB on the bottom of the metallization stack, while FIG. 11 illustrates three metallization stacks and a coaxial cable (CC1) on the top and a multilayer PCB 1126 on the bottom. Similar to FIG. 7B, the multilayer PCB 1126 has a PCB ground 1128 and a PCB signal line 1130.

It should be noted that, because the example of FIG. 11 illustrates a coaxial cable connection at the top, an additional layer 206 is provided on the very top of the vertical stack (over or as a part of MS1), in order to realize a cryogenic compatible electrical connection to the coaxial cable. FIG. 11 further illustrates that superconducting spacers 1132 may be provided in between ground planes of different metallization stacks, indicated in FIG. 11 with superconducting spacers 1132 between metallization stack MS2 and metallization stack MS3. As previously described herein, such superconducting spacers may be combined with one or more dielectric spacers, shown in FIG. 11 with a dielectric spacer 1101, creating inter-wafer cavities 1134 to control vacuum cavity modes of the packaging.

While embodiments described above are described with reference to superconducting vias provided between two patterned superconducting planes comprising superconducting signal lines and superconducting ground planes, descriptions provided herein are equally applicable to superconducting vias provided between two other corresponding superconducting vias (corresponding in the sense that signal via is provided between two other signal vias and ground vias are provided between other ground vias), or a superconducting via provided between a superconducting line on one side and a superconducting via on the other.

Furthermore, while embodiments described above are described with reference to connections to coaxial cables, in other embodiments other waveguiding structures different from a coaxial cable may equally be employed, such as but not limited to PCBs.

Metallization stacks disclosed herein and processes for forming such metallization stacks may be used in the fabrication of vertical quantum I/O structures where one or more metallization stacks are vertically stacked over one another, e.g. as shown in FIGs. 10A, 10B, and 11. In such embodiments, a substrate of one metallization stack may include, for instance, an integrated circuit die. A substrate of another metallization stack may include, for instance, a filter module, or another integrated circuit die. Generally, a purpose of a vertical I/O structure is to allow I/O to a quantum chip from the vertical dimension. In some embodiments, the metallization stacks as described herein may be used to couple a quantum IC to a ball grid array (BGA) that can subsequently be coupled to a further substrate.

Quantum IC packages comprising metallization stacks as described herein may further include embedded devices, including both passive and active devices. Such devices include, but are not limited to, capacitors, decoupling capacitors, resistors, inductors, attenuators, transformers, sensors, and electrostatic discharge (ESD) devices. More complex devices such as radio-frequency (RF) devices, microwave-frequency amplifiers, antennas, arrays, sensors, and MEMS devices may also be formed in the quantum IC packages described herein.

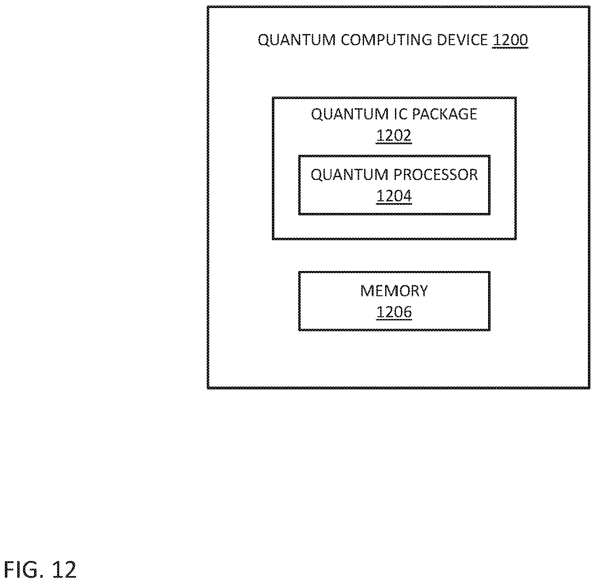

FIG. 12 illustrates a quantum computing device, according to some embodiments of the present disclosure.

The computing device 1200 may be any electronic device that processes quantum information. In some embodiments, the computing device 1200 may include a number of components, including, but not limited to, a quantum IC package 1202, a quantum processor 1204, and a memory 1206, as shown in FIG. 12. The quantum IC package 1202 may include metallization stacks as described herein and could be used to build at least parts of the quantum processor 1204. The processor 1204 may be a universal quantum computer or a specialized quantum processor configured to run quantum simulations or one or more of particular quantum alghoritms, to execute algorithms that may be particularly suitable for quantum computers, such as e.g. cryptographic algorithms that utilize prime factorization, algorithms to optimize chemical reactions, protein folding algorithms. The term "processor" may refer to any device or portion of a device that processes quantum information.

In various embodiments, the computing device 1200 may include other components not shown in FIG. 12, such as e.g. one or more of a controller, I/O channels/devices, a cryogenic apparatus, supplementary microwave control electronics, and a user interface.

The above description of illustrated implementations of the disclosure, including, is not intended to be exhaustive or to limit the disclosure to the precise forms disclosed. While specific implementations of, and examples for, the disclosure are described herein for illustrative purposes, various modifications are possible within the scope of the appended claim set, as those skilled in the relevant art will recognize.

These modifications may be made to the disclosure in light of the above detailed description. The scope of the protection of the invention is to be determined by the following independent claims and optional features are specified by the dependent claims.

**Claims**

1. A superconducting package (100) for providing direct current, DC, and microwave-frequency connectivity in a quantum processor, the superconducting package comprising:

    a first substrate (102) having a top surface (104) and a bottom surface (106) and having at least one quantum circuit component (1204) provided thereon, each of the top and bottom surfaces of the first substrate comprising a patterned superconducting surface;
    a first superconducting signal via (108) extending between the top surface (104) and the bottom surface (106) of the first substrate; and
    a plurality of first superconducting ground vias (110) extending between the top surface and the bottom surface of the first substrate substantially parallel to the first signal via (108) and arranged in a first ring with the first superconducting signal via (108) being at a center of the first ring;
    wherein each of the first superconducting signal via (108) and the plurality of first superconducting ground vias (110) comprises an opening extending between the top surface and the bottom surface of the first substrate, the opening coated with a layer of a superconducting material having a thickness of at least 50 nanometers,nm.

2. The superconducting package according to claim 1, wherein a diameter of the opening is between 10 and 160 micrometers.

3. The superconducting package according to claim 1, wherein a ratio between a depth of the opening and a diameter of the opening is between 7 and 50.

4. The superconducting package according to any one of the preceding claims, wherein a distance between a center of the first superconducting signal via and a center of one of the plurality of first superconducting ground vias is between 100 and 600 micrometers.

5. The superconducting package according to any one of the preceding claims, further comprising one or more blind vias provided in the top surface or/and in the bottom surface of the first substrate.

6. The superconducting package according to any one of the preceding claims, wherein the first substrate comprises sapphire.

7. The superconducting package according to any one of the preceding claims, wherein the bottom surface of the first substrate is coated with a layer of indium.

8. The superconducting package according to any one of the preceding claims, further comprising:

    a second substrate having a top surface and a bottom surface, each of the top and bottom surfaces of the second substrate comprising a patterned superconducting surface;
    a second superconducting signal via extending between the top surface and the bottom surface of the second substrate; and
    a plurality of second superconducting ground vias extending between the top surface and the bottom surface of the second substrate substantially parallel to the second superconducting signal via and arranged in a second ring with the second superconducting signal via being at a center of the second ring;
    wherein the second superconducting signal via and the plurality of second superconducting ground vias are configured to provide DC and microwave-frequency connectivity to said at least one quantum circuit component provided on the first substrate.

9. The superconducting package according to claim 8, wherein each of the second superconducting signal via and the plurality of second superconducting ground vias comprises an opening in the second substrate, the opening coated with a layer of a superconducting material having a thickness of at least 50 nm.

10. The superconducting package according to claims 8 or 9, wherein the second superconducting signal via and the plurality of second superconducting ground vias are separated from, respectively, the first superconducting signal via and the plurality of first superconducting ground vias by one or more dielectric spacers having a thickness between 100

**11.** The superconducting package according to any one of the preceding claims, further comprising a coaxial cable comprising a signal conductor and a ground conductor wherein the signal conductor of the coaxial cable is electrically connected to the first superconducting signal via and the ground conductor of the coaxial cable is electrically connected to the plurality of first superconducting ground vias.

**12.** The superconducting package according to any one of the preceding claims, further comprising a printed circuit board, PCB, comprising a signal connection and a ground connection, wherein the signal connection of the PCB is electrically connected to the first superconducting signal via and the ground connection of the PCB is electrically connected to the plurality of first superconducting ground vias.

**13.** The superconducting package according to the preceding claims, wherein the at least one quantum circuit component comprises a microwave signal line, a quantum bit (qubit), a quantum processing device, or a quantum memory device.

**14.** A method of forming a superconducting package for providing microwave frequency connectivity in a quantum computer, the method comprising:

forming (606) openings for a superconducting signal via and a plurality of superconducting ground vias in a substrate, the openings extending between a top surface and a bottom surface of the substrate substantially parallel to one another,

wherein the openings for the plurality of superconducting ground vias are arranged in a ring with the opening for the superconducting signal via being at a center of the ring, and each of the top and bottom surfaces of the substrate comprises a patterned superconducting surface; and

depositing (608) a layer of a superconducting material having a thickness of at least 50 nanometers, nm, on sidewalls of the openings.

**Patentansprüche**

**1.** Supraleitende Anordnung (100) zur Bereitstellung von Gleichstrom-, DC, und Mikrowellenfrequenz-Konnektivität in einem Quantenprozessor, wobei die supraleitende Anordnung aufweist:

ein erstes Substrat (102), das eine obere Oberfläche (104) und eine untere Oberfläche (106) hat und an dem mindestens eine Quantenschaltungskomponente (1204) bereitgestellt ist, wobei sowohl die obere als auch die untere Oberfläche des ersten Substrats eine strukturierte supraleitende Oberfläche aufweist;
ein erstes supraleitendes Signalkontaktloch (108), das sich zwischen der oberen Oberfläche (104) und der unteren Oberfläche (106) des ersten Substrats erstreckt; und
mehrere erste supraleitende Erdungskontaktlöcher (110), die sich zwischen der oberen Oberfläche und der unteren Oberfläche des ersten Substrats im Wesentlichen parallel zu dem ersten Signalkontaktloch (108) erstrecken und in einem ersten Ring angeordnet sind, wobei das erste supraleitende Signalkontaktloch (108) in einer Mitte des ersten Rings ist;
wobei sowohl das erste supraleitende Signalkontaktloch (108) als auch jedes der mehreren ersten supraleitenden Erdungskontaktlöcher (110) eine Öffnung aufweist, die sich zwischen der oberen Oberfläche und der unteren Oberfläche des ersten Substrats erstreckt, und die Öffnung mit einer Schicht aus einem supraleitenden Material beschichtet ist, die eine Dicke von mindestens 50 Nanometer, nm, hat.

**2.** Supraleitende Anordnung nach Anspruch 1, wobei ein Durchmesser der Öffnung zwischen 10 und 160 Mikrometer ist.

**3.** Supraleitende Anordnung nach Anspruch 1, wobei ein Verhältnis zwischen einer Tiefe der Öffnung und einem Durchmesser der Öffnung zwischen 7 und 50 ist.

**4.** Supraleitende Anordnung nach einem der vorstehenden Ansprüche, wobei ein Abstand zwischen einer Mitte des ersten supraleitenden Signalkontaktlochs und einer Mitte eines der mehreren ersten supraleitenden Erdungskontaktlöchern zwischen 100 und 600 Mikrometer ist.

**5.** Supraleitende Anordnung nach einem der vorstehenden Ansprüche, ferner aufweisend ein oder mehrere Blindkontaktlöcher, die in der oberen Oberfläche und/oder in der unteren Oberfläche des ersten Substrats bereitgestellt sind.

**6.** Supraleitende Anordnung nach einem der vorstehenden Ansprüche, wobei das erste Substrat Saphir aufweist.

**7.** Supraleitende Anordnung nach einem der vorstehenden Ansprüche, wobei die untere Oberfläche des ersten Substrats mit einer Schicht Indium beschichtet ist.

8. Supraleitende Anordnung nach einem der vorstehenden Ansprüche, ferner aufweisend:

ein zweites Substrat mit einer oberen Oberfläche und einer unteren Oberfläche, wobei sowohl die obere als auch die untere Oberfläche des zweiten Substrats eine strukturierte supraleitende Oberfläche aufweist;
ein zweites supraleitendes Signalkontaktloch, das sich zwischen der oberen Oberfläche und der unteren Oberfläche des zweiten Substrats erstreckt; und
mehrere zweite supraleitende Erdungskontaktlöcher, die sich zwischen der oberen Oberfläche und der unteren Oberfläche des zweiten Substrats im Wesentlichen parallel zu dem zweiten Signalkontaktloch erstrecken und in einem zweiten Ring angeordnet sind, wobei das zweite supraleitende Signalkontaktloch in einer Mitte des zweiten Rings ist;
wobei das zweite supraleitende Signalkontaktloch und die mehreren zweiten supraleitenden Erdungskontaktlöcher konfiguriert sind, um der mindestens einen an dem ersten Substrat bereitgestellten Quantenschaltungskomponente DC- und Mikrowellenfrequenz-Konnektivität bereitzustellen.

9. Supraleitende Anordnung nach Anspruch 8, wobei sowohl das zweite supraleitende Signalkontaktloch als auch jedes der mehreren zweiten supraleitenden Erdungskontaktlöcher eine Öffnung in dem zweiten Substrat aufweist, und die Öffnung mit einer Schicht aus einem supraleitenden Material beschichtet ist, die eine Dicke von mindestens 50 nm hat.

10. Supraleitende Anordnung nach einem der Ansprüche 8 oder 9, wobei das zweite supraleitende Signalkontaktloch und die mehreren zweiten supraleitenden Erdungskontaktlöcher jeweils von dem ersten supraleitenden Signalkontaktloch und den mehreren ersten supraleitenden Erdungskontaktlöchern mittels eines oder mehrerer dielektrischer Distanzstücke, die eine Dicke zwischen 100nm und 100μm haben, voneinander getrennt sind.

11. Supraleitende Anordnung nach einem der vorstehenden Ansprüche, ferner aufweisend ein Koaxialkabel, das einen Signalleiter und einen Erdungsleiter aufweist, wobei der Signalleiter des Koaxialkabels elektrisch mit dem ersten supraleitenden Signalkontaktloch verbunden ist und der Erdungsleiter des Koaxialkabels elektrisch mit den mehreren ersten supraleitenden Erdungskontaktlöchern verbunden ist.

12. Supraleitende Anordnung nach einem der vorstehenden Ansprüche, ferner aufweisend eine gedruckte Schaltkarte, PCB, die einen Signalanschluss und einen Erdungsanschluss aufweist, wobei der Signalanschluss der PCB elektrisch mit dem ersten supraleitenden Signalkontaktloch verbunden ist und der Erdungsanschluss der PCB elektrisch mit den mehreren ersten supraleitenden Erdungskontaktlöchern verbunden ist.

13. Supraleitende Anordnung nach einem der vorstehenden Ansprüche, wobei die mindestens eine Quantenschaltungskomponente eine Mikrowellensignalleitung, ein Quantenbit (qubit), eine Quantenverarbeitungsvorrichtung oder eine Quantenspeichervorrichtung aufweist.

14. Verfahren zur Herstellung einer supraleitenden Anordnung zur Bereitstellung von Mikrowellenfrequenz-Konnektivität in einem Quantencomputer, wobei das Verfahren aufweist:

Bilden (606) von Öffnungen für ein supraleitendes Signalkontaktloch und für mehrere supraleitende Erdungslöcher in einem Substrat, wobei die Öffnungen sich zwischen einer oberen Oberfläche und einer unteren Oberfläche des Substrats im Wesentlichen parallel zueinander erstrecken,
wobei die Öffnungen für die mehreren supraleitenden Erdungskontaktlöcher in einem Ring angeordnet sind, und die Öffnung für das supraleitende Signalkontaktloch in einer Mitte des Rings ist, und
sowohl die obere als auch untere Oberfläche des Substrats eine strukturierte supraleitende Oberfläche aufweist; und
Aufbringen (608) einer Schicht eines supraleitenden Materials, die eine Dicke von mindestens 50 Nanometer, nm, hat, auf Seitenwände der Öffnungen.

**Revendications**

1. Ensemble supraconducteur (100) pour la fourniture d'un courant continu, CC, et d'une connectivité hyperfréquence dans un processeur quantique, l'ensemble supraconducteur comprenant :

un premier substrat (102) ayant une surface supérieure (104) et une surface inférieure (106) et ayant au moins un composant de circuit quantique (1204) ménagé sur celui-ci, chacune des surfaces supérieure et inférieure du premier substrat comprenant une surface supraconductrice à motifs ;
un premier trou d'interconnexion de signal supraconducteur (108) s'étendant entre la surface supérieure (104) et la surface inférieure (106) du premier substrat ; et

une pluralité de premiers trous d'interconnexion de masse supraconducteurs (110) s'étendant entre la surface supérieure et la surface inférieure du premier substrat sensiblement en parallèle du premier trou d'interconnexion de signal (108) et agencés en un premier anneau avec le premier trou d'interconnexion de signal supraconducteur (108) étant au centre du premier anneau ;

dans lequel chacun du premier trou d'interconnexion de signal supraconducteur (108) et de la pluralité de premiers trous d'interconnexion de masse supraconducteurs (110) comprend une ouverture s'étendant entre la surface supérieure et la surface inférieure du premier substrat, l'ouverture étant revêtue avec une couche d'un matériau supraconducteur ayant une épaisseur d'au moins 50 nanomètres, nm.

2. Ensemble supraconducteur selon la revendication 1, dans lequel un diamètre de l'ouverture est entre 10 et 160 micromètres.

3. Ensemble supraconducteur selon la revendication 1, dans lequel un rapport entre une profondeur de l'ouverture et un diamètre de l'ouverture est entre 7 et 50.

4. Ensemble supraconducteur selon l'une quelconque des revendications précédentes, dans lequel une distance entre un centre du premier trou d'interconnexion de signal supraconducteur et un centre de l'un de la pluralité de premiers trous d'interconnexion de masse supraconducteurs est entre 100 et 600 micromètres.

5. Ensemble supraconducteur selon l'une quelconque des revendications précédentes, comprenant en outre un ou plusieurs trous d'interconnexion borgnes ménagés dans la surface supérieure ou/et dans la surface inférieure du premier substrat.

6. Ensemble supraconducteur selon l'une quelconque des revendications précédentes, dans lequel le premier substrat comprend du saphir.

7. Ensemble supraconducteur selon l'une quelconque des revendications précédentes, dans lequel la surface inférieure du premier substrat est revêtue avec une couche d'indium.

8. Ensemble supraconducteur selon l'une quelconque des revendications précédentes, comprenant en outre :

un second substrat ayant une surface supérieure et une surface inférieure, chacune des surfaces supérieure et inférieure du second substrat comprenant une surface supraconductrice à motifs ;

un second trou d'interconnexion de signal supraconducteur s'étendant entre la surface supérieure et la surface inférieure du second substrat ; et

une pluralité de seconds trous d'interconnexion de masse supraconducteurs s'étendant entre la surface supérieure et la surface inférieure du second substrat sensiblement en parallèle du second trou d'interconnexion de signal et agencés en un second anneau avec le second trou d'interconnexion de signal supraconducteur étant au centre du second anneau ;

dans lequel le second trou d'interconnexion de signal supraconducteur et la pluralité de seconds trous d'interconnexion de masse supraconducteurs sont configurés pour fournir un CC et une connectivité hyperfréquence audit au moins un composant de circuit quantique ménagé sur le premier substrat.

9. Ensemble supraconducteur selon la revendication 8, dans lequel chacun du second trou d'interconnexion de signal supraconducteur et de la pluralité de seconds trous d'interconnexion de masse supraconducteurs comprend une ouverture dans le second substrat, l'ouverture étant revêtue avec une couche d'un matériau supraconducteur ayant une épaisseur d'au moins 50 nm.

10. Ensemble supraconducteur selon les revendications 8 ou 9, dans lequel le second trou d'interconnexion de signal supraconducteur et la pluralité de seconds trous d'interconnexion de masse supraconducteurs sont séparés, respectivement, du premier trou d'interconnexion de signal supraconducteur et de la pluralité de premiers trous d'interconnexion de masse supraconducteurs par une ou plusieurs entretoises diélectriques ayant une épaisseur entre 100 nm et 100 microns.

11. Ensemble supraconducteur selon l'une quelconque des revendications précédentes, comprenant en outre un câble coaxial comprenant un conducteur de signal et un conducteur de masse dans lequel le conducteur de signal du câble coaxial est électriquement connecté au premier trou d'interconnexion de signal supraconducteur et le conducteur de masse du câble coaxial est électriquement connecté à la pluralité de premiers trous d'interconnexion de masse supraconducteurs.

12. Ensemble supraconducteur selon l'une quelconque des revendications précédentes, comprenant en outre une carte de circuit imprimé, PCB, comprenant une connexion de signal et une connexion de masse, dans lequel la connexion de signal de la PCB est électriquement connectée au premier trou d'interconnexion de signal supraconducteur et la connexion de masse de la PCB est électriquement connectée à la pluralité de premiers trous d'interconnexion de masse supraconducteurs.

13. Ensemble supraconducteur selon les revendications précédentes, dans lequel l'au moins un composant de circuit quantique comprend une ligne de signal hyperfréquence, un bit quantique (qubit), un dispositif de traitement quantique ou un dispositif de mémoire quantique.

14. Procédé de formation d'un ensemble supraconducteur pour la fourniture d'une connectivité hyperfréquence dans un ordinateur quantique, le procédé comprenant :

la formation (606) d'ouvertures pour un trou d'interconnexion de signal supraconducteur et une pluralité de trous d'interconnexion de masse supraconducteurs dans un substrat, les ouvertures s'étendant entre une surface supérieure et une surface inférieure du substrat sensiblement en parallèle les unes par rapport aux autres, dans lequel les ouvertures pour la pluralité de trous d'interconnexion de masse supraconducteurs sont agencées en un anneau avec l'ouverture pour le trou d'interconnexion de signal supraconducteur étant au centre de l'anneau, et chacune des surfaces supérieure et inférieure du substrat comprend une surface supraconductrice à motifs ; et
le dépôt (608) d'une couche d'un matériau supraconducteur ayant une épaisseur d'au moins 50 nanomètres, nm, sur les parois latérales des ouvertures.

FIG. 1

FIG. 2

FIG. 3

EP 3 427 310 B1

FIG. 4

FIG. 5

```
                                                          600

┌─────────────────────────────────────────────────────┐
│      DEPOSIT SUPERCONDUCTING FILM ON A TOP SURFACE    │
│                          602                          │
└─────────────────────────────────────────────────────┘
                            │
                            ▼
┌─────────────────────────────────────────────────────┐
│      PATTERN SUPERCONDUCTING FILM ON THE TOP SURFACE  │
│                          604                          │
└─────────────────────────────────────────────────────┘
                            │
                            ▼
┌─────────────────────────────────────────────────────┐
│                  PROVIDE VIA OPENINGS                 │
│                          606                          │
└─────────────────────────────────────────────────────┘
                            │
                            ▼
┌─────────────────────────────────────────────────────┐
│  CONFORMALLY DEPOSIT SUPERCONDUCTING FILM IN THE OPENINGS │
│                          608                          │
└─────────────────────────────────────────────────────┘
                            │
                            ▼
┌─────────────────────────────────────────────────────┐
│   PATTERN SUPERCONDUCTING FILM ON THE BOTTOM SURFACE  │
│                          610                          │
└─────────────────────────────────────────────────────┘
                            │
                            ▼
┌─────────────────────────────────────────────────────┐
│              (OPTIONAL) DEPOSIT AuPd LAYER            │
│                          612                          │
└─────────────────────────────────────────────────────┘
                            │
                            ▼
┌─────────────────────────────────────────────────────┐
│            (OPTIONAL) DEPOSIT INDIUM LAYER           │
│                          614                          │
└─────────────────────────────────────────────────────┘
```

FIG. 6

FIG. 7A

FIG. 7B

23

| | 102 |
| | 202 |
| | 204 |
| | 206 |

FIG. 8

FIG. 9A

FIG. 9B

FIG. 9C

FIG. 10A

1001

d

FIG. 10B

FIG. 11

EP 3 427 310 B1

QUANTUM COMPUTING DEVICE 1200

QUANTUM IC PACKAGE
1202

QUANTUM PROCESSOR
1204

MEMORY
1206

FIG. 12

EP 3 427 310 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014168665 A2

- US 2006255876 A1